# EUROPEAN PATENT APPLICATION

(11) **EP 1 635 224 A2**
(43) Date of publication of application: **15.03.2006**
(21) Application number: 05018230.2
(22) Date of filing: 23.08.2005
(51) Int. Cl.: G03F 7/42

(54) **Composition for removing a photoresist residue and polymer residue, and residue removal process using the same**

(30) Priority: 25.08.2004 JP 2004245717
(71) Applicant: Kanto Kagaku Kabushiki Kaisha, Chuo-ku Tokyo (JP)
(72) Inventor: Hata, Kisato, Soka-shi, Saitama (JP); Oowada, Takuo, c/o Kanto Kagaku K. K., Chuo-ku, Tokyo (JP)
(74) Representative: Flaccus, Rolf-Dieter

(57) **Abstract**

A composition for removing a photoresist residue and polymer residue to remove a photoresist residue and an ashing residue remaining after dry etching and after ashing of a semiconductor substrate having metal wiring formed from aluminum or an aluminum alloy is provided, the composition containing at least one type of fluorine compound (excluding hydrofluoric acid), at least one type of sulfonic acid, and water.

## Description

### BACKGROUND OF THE INVENTION

### Field of the Invention

The present invention relates to a composition for removing a photoresist residue and polymer residue remaining after dry etching and after ashing of a semiconductor substrate having metal wiring comprising aluminum or an aluminum alloy, and to a residue removal process using same.

### Description of the Related Art

In a process for fabricating a semiconductor circuit device dry etching, in which a via hole is provided in an interlayer insulating film formed on a substrate, or a film of a wiring material such as aluminum is subjected to patterning using a photoresist pattern as a mask, has conventionally been carried out. As a posttreatment for dry etching, after the resist pattern is ashed and removed by an ashing treatment, a photoresist residue, a polymer residue, etc. partially remaining on the treated surface is usually removed by a special purpose composition (residue removal composition). The photoresist residue referred to here means an incompletely ashed product of a photoresist, an anti-reflection film, etc. remaining on the substrate surface after dry etching and after ashing, and the polymer residue referred to here means a fluorocarbon deposit originating from an etching gas during dry etching that remains on an etched material wall surface as a by-product, a side wall polymer such as a compound between a wiring metal and an etching gas (also called a side wall protecting film or a rabbit ear), and an organometallic polymer and a metal oxide remaining on a side face and a base face of a via hole.

With regard to conventional compositions for removing a photoresist residue and polymer residue, in the case in which wiring is made of aluminum or an aluminum alloy, a composition for removing a photoresist residue and polymer residue comprising 'a fluorine compound + a quaternary ammonium compound + water' or 'a fluorine compound + a quaternary ammonium compound + an organic solvent + water', and a composition for removing a photoresist residue and polymer residue comprising 'a hydroxylamine + an alkanolamine (+ solvent)' have been proposed (e.g., JP, A, 7-201794 and US Pat. No. 5334332). Although these compositions for removing a photoresist residue and polymer residue have low corrosivity toward aluminum or an aluminum alloy and can be used both after formation of metal wiring and after formation of a via hole or a contact hole, it is necessary to employ a long treatment time of 20 to 30 minutes in order to completely remove attached photoresist residue and polymer residue. Because of this, the above-mentioned compositions for removing a photoresist residue and polymer residue cannot be used in a single wafer washing system, which has been introduced into a photoresist residue removal step in recent years and requires a short processing time at low temperature (usually, the treatment temperature is 25°C to 40°C, and the treatment time is 1 to 3 minutes).

On the other hand, with regard to examples of a composition in which a fluorine compound is combined with an acid, it has been reported that an etching composition comprising 'a fluorine compound + sulfuric acid + hydrogen peroxide or ozone + water' can remove a photoresist residue and a polymer residue by a treatment for a short time at low temperature, and has low corrosivity toward an aluminum alloy (e.g., JP, A, 11-243085). However, the corrosion prevention properties toward an aluminum alloy are insufficient for it to be used in an actual single wafer washing system, and since the maximum content of the fluorine compound is 100 ppm, which is a low concentration, removal of a photoresist residue and a polymer residue containing a large amount of silicon after formation of a via hole is inadequate. Furthermore, since hydrogen peroxide or ozone decomposes, the stability over time of the composition for removing a photoresist residue and polymer residue itself is a problem. Other than the above, a composition for removing photoresist residue comprising 'ammonium fluoride + an organic acid + water' has been reported (e.g., JP, A, 6-349785), but the odor of acetic acid, which is used as the organic acid, is strong and the workability is poor. Furthermore, a composition for removing a photoresist residue and polymer residue comprising 'a fluorine compound + a reducing acid' can remove a photoresist residue and a polymer residue by a treatment for a short time at low temperature and has low corrosivity toward copper, a copper alloy, and a low permittivity film (e.g., JP, A, 2003-280219), but the corrosion prevention properties toward aluminum or an aluminum alloy are not sufficient.

With regard to examples of a composition in which a fluorine compound, an acid, and an organic solvent are combined, a composition for removing a photoresist residue and polymer residue comprising 'a fluorine compound + ascorbic acid + a polar organic solvent' has been reported (e.g., JP, A, 2001-5200), but since ascorbic acid itself decomposes over time in aqueous solution, the composition is not practical. Furthermore, a composition for removing a photoresist residue and polymer residue comprising 'a fluorine compound + orthoboric acid or orthophosphoric acid + a water-soluble organic solvent' (e.g., JP, A, 11-67703) has the purpose of removing a photoresist residue and a polymer residue when forming a via hole, but orthoboric acid and orthophosphoric acid, which are for suppressing damage to an interlayer insulating film, do not have corrosion prevention properties toward a metal such as aluminum, and the composition cannot be used for the removal of a photoresist residue and a polymer residue during formation of wiring when a large area of a metal such as aluminum is exposed. Moreover, a composition for removing a photoresist residue and polymer residue comprising 'a fluorine compound + a sulfonic acid based buffer + a water-soluble organic solvent' (e.g., JP, A, 2003-241400) has low corrosivity toward copper, but it is not described as having corrosion prevention properties toward aluminum and an aluminum alloy.

Furthermore, with regard to a process for fabricating a semiconductor circuit device, there have been reported a method for washing or etching the surface of a silicon wafer using a treatment liquid comprising at least one type selected from hydrofluoric acid, hydrochloric acid, nitric acid, aqueous hydrogen peroxide, acetic acid, ammonium fluoride, and phosphoric acid, and a surfactant (JP, A, 6-41770), an in-solution foreign matter attachment-prevention solution formed by adding an anionic surfactant to a mixed solution of an acid and aqueous ammonia so as to control the zeta potential of micro particles present in the solution (JP, A, 6-132267), a wet etching composition formed by adding a surfactant comprising an alkylsulfonic acid and an ω-hydrofluoroalkylcarboxylic acid to a buffered hydrofluoric acid comprising hydrogen fluoride, ammonium fluoride, and water (JP, A, 2002-69674), etc. However, all of these treatment liquids basically employ hydrofluoric acid, and when a treatment liquid containing hydrofluoric acid is used for removing a photoresist residue and a polymer residue, since an interlayer insulating film is etched, these compositions are not suitable for removal of a photoresist residue and a polymer residue.

As described above, the current semiconductor circuit device fabrication processes employ a residue removal composition for removing a photoresist residue and a polymer residue formed by ashing a photoresist after dry etching in a step of forming wiring comprising aluminum or an aluminum alloy on a substrate surface and in a step of forming a via hole providing an interwiring connection or a contact hole providing a connection between a transistor layer and wiring therefor. However, there is no known composition for removing a photoresist residue and polymer residue that has good residue removability for a photoresist residue, formed after formation of metal wiring and after formation of a via hole, by a treatment for a short time at low temperature as well as good corrosion prevention properties toward the metal wiring, and that can be applied to a single wafer washing system. Because of this, there has been a desire for the development of a composition for removing a photoresist residue and polymer residue that can satisfy all of these performance requirements.

### SUMMARY OF THE INVENTION

It is therefore an object of the present invention to provide a composition for removing a photoresist residue and polymer residue to remove a photoresist residue and a polymer residue formed during a fabrication process for a semiconductor circuit device, and a residue removal process using same; in particular, it is an object of the present invention to provide a composition for removing a photoresist residue and polymer residue that can remove, by a treatment for short time at low temperature, a photoresist residue remaining after formation of metal wiring and after formation of a via hole, that has corrosion prevention properties toward metal wiring, and that can be applied to a single wafer washing system, and a residue removal process using same.

During an intensive investigation in order to solve the above-mentioned problems, the present inventors have found that, by adding a sulfonic acid to a composition for removing a photoresist residue and polymer residue that includes a fluorine compound, it is possible to improve not only the effect of removing a photoresist residue and a polymer residue by virtue of dissociation of HF₂⁻, but also to improve the corrosion prevention properties toward metal wiring comprising aluminum or an aluminum alloy, and it can therefore be applied to a single wafer washing system, which requires a short processing time at low temperature, and the present invention has thus been accomplished.

That is, the present invention relates to a composition for removing a photoresist residue and polymer residue to remove a photoresist residue and polymer residue remaining after dry etching and after ashing of a semiconductor substrate having metal wiring comprising aluminum or an aluminum alloy, the composition comprising at least one type of fluorine compound (excluding hydrofluoric acid), at least one type of sulfonic acid, and water.

Furthermore, the present invention relates to the composition for removing a photoresist residue and polymer residue, wherein the sulfonic acid is R¹SO₃H (R¹ denotes an alkyl group having 1 to 4 carbons) or R²-A-SO₃H (R² denotes an alkyl group having 1 to 16 carbons, and A denotes a phenylene group).

Moreover, the present invention relates to the composition for removing a photoresist residue and polymer residue, wherein the fluorine compound is ammonium fluoride.

Furthermore, the present invention relates to the composition for removing a photoresist residue and polymer residue, wherein the composition further comprises up to 50 mass % of a water-soluble organic solvent.

Moreover, the present invention relates to the composition for removing a photoresist residue and polymer residue, wherein the water-soluble organic solvent is a cyclic amine, an ether, or an alcohol.

Furthermore, the present invention relates to the composition for removing a photoresist residue and polymer residue, wherein the composition further comprises a surfactant.

Moreover, the present invention relates to a process for removing a photoresist residue and polymer residue remaining after dry etching and after ashing of a semiconductor substrate having metal wiring comprising aluminum or an aluminum alloy, the process comprising using a composition for removing a photoresist residue and polymer residue comprising at least one type of fluorine compound (excluding hydrofluoric acid), at least one type of sulfonic acid, and water.

Since the composition for removing a photoresist residue and polymer residue of the present invention comprises a fluorine compound and a sulfonic acid, it can improve both the removability of a photoresist residue and a polymer residue and the corrosion prevention properties toward metal wiring. The sulfonic acid affects both the removability of a photoresist residue and a polymer residue and the corrosion prevention properties toward aluminum or an aluminum alloy. It is surmised that this is due to a change in the concentration of HF₂⁻, which is a dissociated ion species originating from the fluorine compound, according to the amount of sulfonic acid added. For example, ammonium fluoride dissociates to HF₂⁻ in aqueous solution as shown in the expression below.

H⁺ + 2NH₄F → HF₂⁻ + 2NH₄⁺

When the amount of sulfonic acid (H⁺) added is small, since the concentration of HF₂⁻ formed is low, the removability of a photoresist residue and a polymer residue and the corrosion of aluminum or an aluminum alloy are both suppressed, but when the amount of sulfonic acid added is large, since the concentration of HF₂⁻ formed is high, the removability of a photoresist residue and a polymer residue and the corrosion of aluminum or an aluminum alloy are both increased. Therefore, by adjusting the amounts of fluorine compound (ammonium fluoride) and sulfonic acid (H⁺) added, the concentration of HF₂⁻ can be adjusted, thus balancing the photoresist residue and polymer residue removability and the corrosion of aluminum or an aluminum alloy by HF₂⁻.

Furthermore, the sulfonic acid used in the present invention has the characteristic that, in comparison with other acids, when combined with a fluorine compound the corrosion prevention properties toward aluminum or an aluminum alloy are high. Although the reason therefor is not clear, it is surmised that a sulfonic acid group forms a coating of a poorly water-soluble chelate compound on the aluminum surface, thus suppressing contact between the photoresist residue and polymer residue removing component and metal so as to exhibit an effect of preventing corrosion. When an acid other than a sulfonic acid is used, such as, for example, oxalic acid, tartaric acid, succinic acid, citric acid, malic acid, acetic acid, glyoxylic acid, phosphoric acid, or hexafluorosilicic acid, although the removability of a photoresist residue and a polymer residue improves if the amount thereof added is increased, at the same time the corrosion of aluminum or an aluminum alloy greatly increases. It is surmised that, since these acids have no sulfonic acid group, a poorly water-soluble coating is not formed. Therefore, the use of a sulfonic acid enables metal corrosion by HF₂⁻ to be outstandingly suppressed compared with the use of other acids, and both the removability of a photoresist residue and a polymer residue and the corrosion prevention properties toward aluminum or an aluminum alloy can thus be improved.

### EFFECTS OF THE INVENTION

The composition for removing a photoresist residue and polymer residue of the present invention is a combination of a sulfonic acid and a fluorine compound other than hydrofluoric acid , and by making the ratio of the fluorine compound to the sulfonic acid appropriate the effects of improving the removability of a photoresist residue and a polymer residue and suppressing the corrosion of metal wiring comprising aluminum or an aluminum alloy, which cannot be achieved by the conventional art, can be obtained.

Because of this, the composition for removing a photoresist residue and polymer residue of the present invention can remove a photoresist residue and a polymer residue formed by ashing of a photoresist after dry etching in a step of forming wiring comprising aluminum or an aluminum alloy on a substrate surface and in a step of forming a via hole providing interwiring connection or a contact hole providing a connection between a transistor layer and wiring therefor using a single wafer washing system, which requires a short processing time at low temperature.

### BRIEF DESCRIPTION OF DRAWINGS

FIG. 1 is a diagram showing a process for fabricating a semiconductor circuit device (Al wiring pattern) using the composition for removing a photoresist residue and polymer residue of the present invention present.
FIG. 2 is a diagram showing a process for fabricating a semiconductor circuit device (via hole pattern) using the composition for removing a photoresist residue and polymer residue of the present invention.

### BEST MODE FOR CARRYING OUT THE INVENTION

### [1] Composition for removing a photoresist residue and polymer residue

### (1) Fluorine compound

The fluorine compound used in the composition for removing a photoresist residue and polymer residue of the present invention is a fluoride formed by a reaction between hydrofluoric acid and ammonia or an organic amine. Examples thereof include ammonium fluoride, ammonium hydrogen fluoride, methylamine hydrofluoride, ethylamine hydrofluoride, propylamine hydrofluoride, tetramethylammonium fluoride, tetraethylammonium fluoride, ethanolamine hydrofluoride, methylethanolamine hydrofluoride, dimethylethanolamine hydrofluoride, and triethylenediamine hydrofluoride. Among these, ammonium fluoride is preferable since it has high removability of a photoresist residue and a polymer residue, and a low metallic impurity content, and it is readily available.

In the composition for removing residue, the photoresist residue and polymer residue removability improves if the amount of fluorine compound added is increased, but the corrosivity toward aluminum or an aluminum alloy increases. On the other hand, if the amount of fluorine compound added is decreased, the corrosivity toward aluminum or an aluminum alloy is suppressed, but the photoresist residue and polymer residue removability also deteriorates. The amount of fluorine compound added is appropriately determined according to the removability of a photoresist residue and a polymer residue and the corrosion prevention properties toward aluminum or an aluminum alloy while taking into consideration the amount of sulfonic acid added, but it is preferably 0.01 to 5 mass % relative to the composition, and more preferably 0.05 to 1 mass %.

### (2) Sulfonic acid

The sulfonic acid used in the composition for removing a photoresist residue and polymer residue of the present invention is preferably an alkylsulfonic acid represented by R¹SO₃H (R¹ denotes an alkyl group having 1 to 4 carbons) or an alkylbenzenesulfonic acid represented by R²-A-SO₃H (R² denotes an alkyl group having 1 to 16 carbons, and A denotes a phenylene group), and specific examples thereof include methanesulfonic acid, ethanesulfonic acid, propanesulfonic acid, butanesulfonic acid, p-toluenesulfonic acid, and dodecylbenzenesulfonic acid. The sulfonic acid is more preferably an alkylsulfonic acid (R¹SO₃H), and yet more preferably methanesulfonic acid or ethanesulfonic acid.

When the amount of sulfonic acid added is decreased, the photoresist residue and polymer residue removability deteriorates, and when the amount of sulfonic acid added is increased, the photoresist residue and polymer residue removability improves but the corrosivity toward aluminum or an aluminum alloy also increases. The amount of sulfonic acid added is appropriately determined according to the removability of a photoresist residue and a polymer residue and the corrosion prevention properties toward aluminum or an aluminum alloy while taking into consideration the amount of fluorine compound added, but it is preferably 0.01 to 5 mass % relative to the composition, and more preferably 0.01 to 2 mass %.

The pH of the composition for removing a photoresist residue and polymer residue of the present invention may be in a range that can maintain an appropriate concentration of HF₂⁻, and is preferably 1 to 6.

The ratio of the fluorine compound and the sulfonic acid added is appropriately determined according to the removability of a photoresist residue and a polymer residue and the corrosion prevention properties toward aluminum or an aluminum alloy, but the fluorine compound/sulfonic acid ratio by mass is preferably 5/0.01 to 0.01/5, and more preferably 0.05/0.01 to 0.01/5.

### (3) Water-soluble organic solvent

The composition for removing a photoresist residue and polymer residue of the present invention can further include a water-soluble organic solvent in order to enhance the corrosion prevention properties toward aluminum or an aluminum alloy. The water-soluble organic solvent may be one that has high corrosion prevention properties toward a metal and does not impair the residue removability. Specific preferred examples include cyclic amines such as morpholine, piperidine, piperazine, pyridine, and pyrimidine; ethers such as diethylene glycol monomethyl ether, diethylene glycol monoethyl ether, diethylene glycol monobutyl ether, dipropylene glycol monomethyl ether, dipropylene glycol monoethyl ether, propylene glycol monomethyl ether, propylene glycol monoethyl ether, γ-butyrolactone, and tetrahydrofuran; and alcohols such as ethylene glycol, propylene glycol, and tetrahydrofurfuryl alcohol. By combining the water-soluble organic solvent such as a cyclic amine, an ether, or an alcohol with the fluorine compound and the sulfonic acid, a high residue removability can be obtained while improving the corrosion prevention properties toward aluminum or an aluminum alloy.

Among these, an ether or an alcohol represented by structural formula (1) below:

CH₂XYOZOC₂H₄OH (1)

(here, X denotes hydrogen or a hydroxyl group, Y denotes a straight-chain or branched alkylene group having 0 to 3 carbons, Z denotes a straight-chain or branched alkylene group having 1 to 3 carbons, and a hydrogen of Y or Z may be substituted by a hydroxyl group) is preferable. Specific examples thereof include ethers such as diethylene glycol monomethyl ether, diethylene glycol monoethyl ether, diethylene glycol monobutyl ether, and dipropylene glycol monomethyl ether, and alcohols such as triethylene glycol.

In the composition for removing a photoresist residue and polymer residue of the present invention, when the amount of water-soluble organic solvent added is decreased, the photoresist residue and polymer residue removability improves, but the corrosivity toward aluminum or an aluminum alloy also intensifies. When the amount of water-soluble organic solvent added is increased, the corrosivity toward aluminum or an aluminum alloy is suppressed, but the photoresist residue and polymer residue removability also deteriorates. The amount of water-soluble organic solvent added is therefore appropriately determined according to the removability of a photoresist residue and a polymer residue and the corrosivity toward aluminum or an aluminum alloy while taking into consideration the amounts of fluorine compound and sulfonic acid added, but it is preferably up to 50 mass % relative to the composition, and more preferably 1 to 50 mass %.

### (4) Surfactant

The composition for removing a photoresist residue and polymer residue of the present invention may further comprise a surfactant in order to improve the removability of a metal oxide and particles of an organometallic polymer, etc. contained in the photoresist residue and the polymer residue. Typical examples of the surfactant include an anionic surfactant and a nonionic surfactant. In particular, an anionic surfactant having a sulfonic acid group or a carboxyl group, which are hydrophilic groups, is preferable.

When the amount of surfactant added is decreased, the corrosivity toward aluminum or an aluminum alloy intensifies, and when the amount of surfactant added is increased, the removability of a photoresist residue and a polymer residue deteriorates. The amount of surfactant added is therefore appropriately determined according to the removability of a photoresist residue and a polymer residue and the corrosivity toward aluminum or an aluminum alloy while taking into consideration the amounts of fluorine compound and sulfonic acid added, but it is preferably 0.01 to 1 mass % relative to the composition.

The composition for removing a photoresist residue and polymer residue of the present invention is suitable for pretreatment and post-treatment of multilayer wiring, but it is of course possible to use it for removing a photoresist residue and a polymer residue formed by ashing after dry etching of a semiconductor circuit device on which no metal wiring has been provided.

### [2] Photoresist residue and polymer residue removal process

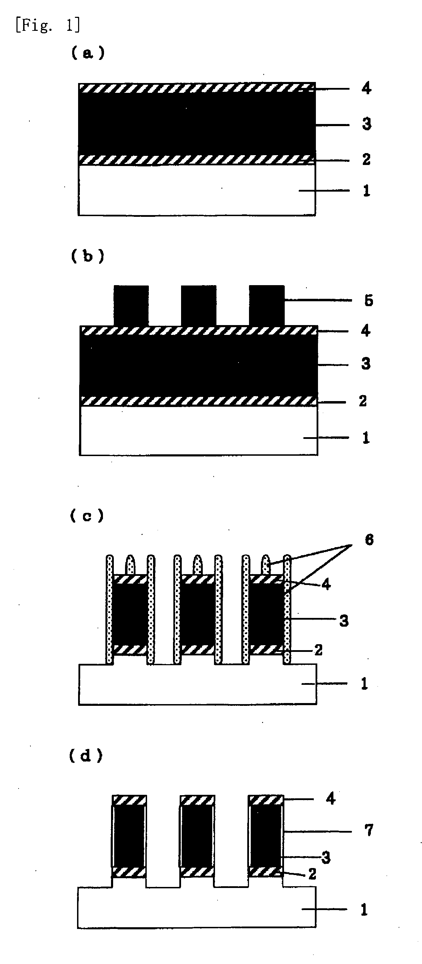

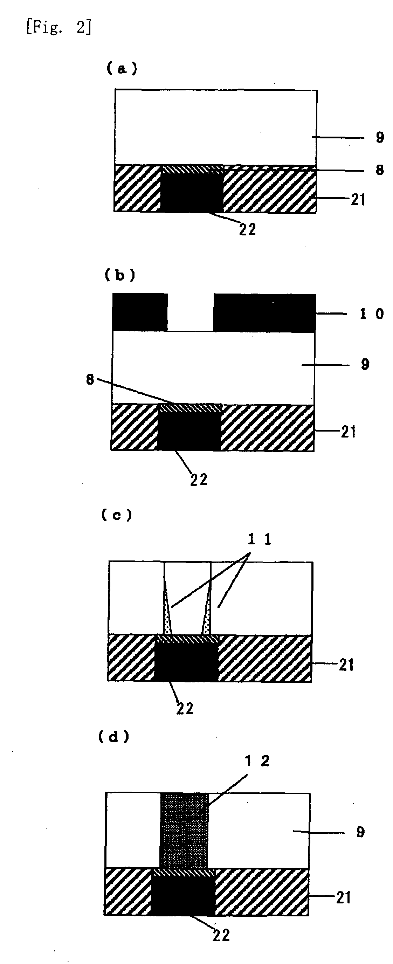

Use of the composition for removing a photoresist residue and polymer residue of the present invention enables a photoresist residue and a polymer residue remaining on wiring side walls and on wiring after dry etching and ashing a wiring material as shown in FIG. 1 to be easily removed. Similarly, as shown in FIG. 2, it can easily remove a photoresist residue, a polymer residue, etc. before embedding a metal of multilayer wiring having a damascene structure, a through hole, etc., and it is possible to prevent lower layers of metal wiring and embedded metal from being corroded, etc. A preferred embodiment of the residue removal process of the present invention in a process for fabricating a semiconductor circuit device is explained below by reference to FIG. 1 and FIG. 2.

A barrier metal layer 2 made of TiN/Ti, etc., a metal layer 3 made of Al, AlCu, etc., and a barrier metal layer 4 made of TiN/Ti, etc. are formed by sputtering, etc. in sequence on a base oxide film 1 made of SiOₓ, etc. shown in FIG. 1 (a); a patterned photoresist mask 5 is formed thereon by coating, exposure, and development (b); dry etching is carried out and the etched mask (photoresist) 5 is ashed (c); and the wafer is washed using the composition for removing a photoresist residue and polymer residue of the present invention. The washing method is not particularly limited; for example, the wafer may be immersed in the residue removal composition, or the residue removal composition may be sprayed on the wafer surface through a nozzle. The composition for removing a photoresist residue and polymer residue of the present invention has high corrosion prevention properties toward aluminum or an aluminum alloy, and there is little wiring thinning 7 due to the washing. The washed wafer is rinsed with running superpure water and dried (d).

After embedded wiring 22 made of Al, etc. and a barrier metal layer 8 made of TiN/Ti, etc. are formed in a wiring trench of an insulating film 21 made of SiO₂, etc. shown in FIG. 2, an interlayer insulating film 9 made of SiO₂, etc. is formed on the insulating film 21 (a), and a patterned photoresist mask 10 is formed thereon by coating, exposure, and development (b). After a via hole is formed in the interlayer insulating film 9 by dry etching, and the etched mask (photoresist) 10 is ashed (c), the wafer is washed using the composition for removing a photoresist residue and polymer residue of the present invention. The washing method is not particularly limited; for example, the wafer may be immersed in the residue removal composition, or the residue removal composition may be sprayed on the wafer surface through a nozzle. The washed wafer is rinsed with running superpure water and dried. An embedded metal (W, AlCu, Cu, etc.) layer 12 is further formed in the via hole of the wafer, and an upper part thereof is planarized to give a semiconductor circuit device (via hole pattern) (d).

The use of the composition for removing a photoresist residue and polymer residue of the present invention can give a high residue removability even in a treatment for short time at low temperature, and it is therefore possible to wash a wafer using a single wafer washing system, which has a washing time of on the order of 1 to 3 minutes. The process of the present invention is of course not limited to the single wafer washing system, and it is possible to carrying out washing using a batch washing system (single vessel type, multi vessel type, etc.).

### [Examples]

The present invention is explained in further detail by reference to Examples below, but the present invention should not be construed as being limited by these Examples.

### Examples 1 to 38 and Comparative Examples 1 to 19

### Process for preparing composition for removing a photoresist residue and polymer residue

(1) A sulfonic acid weighed according to the amount to be charged shown in Table 1 or Table 3 was put into superpure water weighed according to the amount to be charged, and the mixture was stirred until a uniform mixture was obtained (solution A).
(2) A fluorine compound weighed according to the amount to be charged shown in Table 1 or Table 3 was put into the solution A, and the mixture was stirred until a uniform mixture was obtained (solution B).
(3) A water-soluble organic solvent and/or a surfactant weighed according to the amounts to be charged shown in Table 1 or Table 3 were put into the solution B, and the mixture was stirred until a uniform mixture was obtained.

### Evaluation

An Al wiring pattern and a via hole pattern were formed on wafers for evaluation, photoresist residue and polymer residue that remained were washed as described below using compositions for removing a photoresist residue and polymer residue of Examples 1 to 38 and Comparative Examples 1 to 19, and the residue removability and the corrosivity toward Al were evaluated. The results are given in Table 2 and Table 4.

### Evaluation by Al wiring pattern (FIG. 1)

A patterned photoresist mask 5 was formed by coating, exposure, and development on a wafer in which a barrier metal (TiN/Ti) layer 2, a metal (Al) layer 3, and a barrier metal (TiN/Ti) layer 4 were formed on a base oxide film (SiO₂ film) 1; dry etching was carried out, and the etched mask (photoresist) 5 was ashed; such a wafer was immersed in each of the residue removal compositions of Examples 1 to 38 and Comparative Examples 1 to 19 under conditions shown in Table 1 and Table 3 (25°C, 90 seconds), followed by rinsing with running superpure water and drying. The photoresist residue and polymer residue removability and the corrosivity toward Al of the Al wiring pattern thus obtained were evaluated using an electron microscope.

### Evaluation of via hole pattern (FIG. 2)

A patterned photoresist mask 10 was formed by coating, exposure, and development on a wafer in which embedded wiring (Al) 22 and a barrier metal (TiN/Ti) layer 8 were formed in a wiring trench of an insulating film (SiO₂ film) 21 and an interlayer insulating film 9 was formed on the insulating film 21; a via hole was formed by dry etching, and the etched mask (photoresist) 10 was ashed; such a wafer was then immersed in each of the residue removal compositions of Examples 1 to 38 and Comparative Examples 1 to 19 under conditions shown in Table 1 and Table 3 (25°C, 180 seconds), followed by rinsing with running superpure water and drying. The photoresist residue and polymer residue removability and the corrosivity toward Al of the via hole pattern thus obtained were evaluated using an electron microscope.

**[Table 1]**

| | Residue removal composition components mass (%) | | | | | | | |
|---|---|---|---|---|---|---|---|---|
| | Fluorine compound | | Acid | | Water-soluble organic solvent | | Surfactant | |
| Comp. Ex. 1 | EKC-265 *3 | | | | | | | |
| Comp. Ex. 2 | ELM-C30 *4 | | | | | | | |
| Comp. Ex. 3 | SPR-301 *5 | | | | | | | |
| Comp. Ex. 4 | NH₄F | 0.05 | | | | | | |
| Comp. Ex. 5 | NH₄F | 0.1 | | | | | | |
| Camp. Ex. 6 | NH₄F | 0.5 | | | | | | |
| Comp. Ex. 7 | NH₄F | 1.0 | | | | | | |
| Conp. Ex. 8 | NH₄F | 0.05 | Sulfuric acid | 1.0 | | | | |
| Comp. Ex. 9 | NH₄F | 0.05 | Phosphoric acid | 1.0 | | | | |
| Comp. Ex. 10 | NH₄F | 0.05 | Nitric acid | 1.0 | | | | |
| Comp. Ex. 11 | NH₄F | 0.05 | Hydrochloric acid | 1.0 | | | | |
| Comp. Ex. 12 | NH₄F | 0.05 | Boric acid | 1.0 | | | | |
| Comp. Ex. 13 | NH₄F | 0.05 | Acetic acid | 1.0 | | | | |
| Comp. Ex. 14 | NH₄F | 1.0 | Sulfuric acid | 1.0 | | | | |
| Comp. Ex. 15 | NH₄F | 1.0 | Phosphoric acid | 1.0 | | | | |
| Comp. Ex. 16 | NH₄F | 1.0 | Nitric acid | 1.0 | | | | |
| Comp. Ex. 17 | NH₄F | 1.0 | Hydrochloric acid | 1.0 | | | | |
| Comp. Ex. 18 | NH₄F | 1.0 | Boric acid | 1.0 | | | | |
| Comp. Ex. 19 | NH₄F | 1.0 | Acetic acid | 1.0 | | | | |

| | | | | | | | | |
|---|---|---|---|---|---|---|---|---|
| *3: removal liquid containing an amine, manufactured by EKC Technology | | | | | | | | |
| *4: removal liquid containing a fluorine compound and an organic solvent, manufactured by Mitsubishi Gas Chemical Company, Inc. | | | | | | | | |
| *5: removal liquid containing an organic acid, manufactured by Kanto Chemical | | | | | | | | |

**[Table 2]**

| | Evaluation results | | | | | |
|---|---|---|---|---|---|---|
| | Al wiring pattern | | Via hole pattern | | | |
| | (25°C, 90 sec.) | | (25°C, 180 sec.) | | | |
| | Removability *1 | Al corrosion *2 | Removability *1 | Al corrosion *2 | TiN corrosion *2 | Interlayer insulating film corrosion *2 |
| Comp. Ex. 1 | D | A | D | A | A | A |
| Comp. Ex. 2 | D | A | D | A | A | A |
| Comp. Ex. 3 | D | A | D | A | A | A |
| Comp. Ex. 4 | D | B | D | B | A | A |
| Comp. Ex. 5 | D | B | D | B | A | A |
| Comp. Ex. 6 | D | B | D | B | A | A |
| Comp. Ex. 7 | D | B | D | B | A | A |
| Comp. Ex. 8 | A | A | D | B | A | A |
| Comp. Ex. 9 | C | B | D | C | A | A |
| Comp. Ex. 10 | C | C | D | D | B | A |
| Comp. Ex. 11 | B | C | D | D | B | A |
| Comp. Ex. 12 | A | D | D | D | A | A |
| Comp. Ex. 13 | C | B | D | C | A | A |
| Comp. Ex. 14 | A | A | C | A | B | D |
| Comp. Ex. 15 | A | D | C | D | A | D |
| Comp. Ex. 16 | A | D | C | D | C | D |
| Comp. Ex. 17 | A | D | C | D | C | D |
| Comp. Ex. 18 | A | D | C | D | C | C |
| Comp. Ex. 19 | A | D | C | D | B | C |

| | | | | | | |
|---|---|---|---|---|---|---|
| *1: A very good, B good, C some remaining, D impossible to remove | | | | | | |
| *2: A no corrosion, B hardly any corrosion, C slight surface roughness occurred, D etching occurred | | | | | | |

**[Table 3]**

| | Residue removal composition components mass (%) | | | | | | | |
|---|---|---|---|---|---|---|---|---|
| | Fluorine compound | | Sulfonic acid | | Water-soluble organic solvent | | Surfactant *24 | |
| Ex. 1 | NH₄F | 0.05 | MSA *7 | 1.0 | - | - | - | - |
| Ex. 2 | MEA + F | 0.05 | MSA *7 | 1.0 | - | - | - | - |
| Ex. 3 | NH₄F | 0.05 | ESA *8 | 1.0 | - | - | - | - |
| Ex. 4 | NH₄F | 0.05 | PTSA *9 | 1.0 | - | - | - | - |
| Ex. 5 | NH₄F | 0.05 | DBS *10 | 1.0 | - | - | - | - |
| Ex. 6 | NH₄F | 0.01 | MSA *7 | 0.01 | - | - | - | - |
| Ex. 7 | NH₄F | 0.01 | MSA *7 | 5.0 | - | - | - | - |
| Ex. 8 | NH₄F | 0.05 | MSA *7 | 0.01 | - | - | - | - |
| Ex. 9 | NH₄F | 0.05 | MSA *7 | 2.0 | - | - | - | - |
| Ex. 10 | NH₄F | 1.0 | MSA *7 | 0.01 | - | - | - | - |
| Ex. 11 | NH₄F | 1.0 | MSA *7 | 0.1 | - | - | - | - |
| Ex. 12 | NH₄F | 5.0 | MSA *7 | 0.01 | - | - | - | - |
| Ex. 13 | NH₄F | 1.0 | MSA *7 | 1.0 | DEGMME *11 | 30 | - | - |
| Ex. 14 | NH₄F | 1.0 | MSA *7 | 1.0 | DEGMEE *12 | 30 | - | - |
| Ex. 15 | NH₄F | 1.0 | MSA *7 | 1.0 | DEGMBE *13 | 30 | - | - |
| Ex. 16 | NH₄F | 1.0 | MSA *7 | 1.0 | DEGDME *14 | 30 | - | - |
| Ex. 17 | NH₄F | 1.0 | MSA *7 | 1.0 | DPGMME *15 | 30 | - | - |
| Ex. 18 | NH₄F | 1.0 | MSA *7 | 1.0 | DPGMEE *16 | 30 | - | - |
| Ex. 19 | NH₄F | 1.0 | MSA *7 | 1.0 | EG *17 | 30 | - | - |
| Ex. 20 | NH₄F | 1.0 | MSA *7 | 1.0 | PG *I8 | 30 | - | - |
| Ex. 21 | NH₄F | 1.0 | MSA *7 | 1.0 | PGM *19 | 30 | - | - |
| Ex. 22 | NH₄F | 1.0 | MSA *7 | 1.0 | PGE *20 | 30 | - | - |
| Ex. 23 | NH₄F | 1.0 | MSA *7 | 1.0 | THFFA *21 | 30 | - | - |
| Ex. 24 | NH₄F | 1.0 | MSA *7 | 1.0 | GBL *22 | 30 | - | - |
| Ex. 25 | NH₄F | 1.0 | MSA *7 | 1.0 | THF *23 | 30 | - | - |
| Ex. 26 | NH₄F | 1.0 | MSA *7 | 2.0 | Morpholine | 1 | - | - |
| Ex. 27 | NH₄F | 1.0 | MSA *7 | 2.0 | Piperidine | 1 | - | - |
| Ex. 28 | NH₄F | 1.0 | MSA *7 | 2.0 | Piperazine | 1 | - | - |
| Ex. 29 | NH₄F | 1.0 | MSA *7 | 1.0 | DEGMME *11 | 10 | - | - |
| Ex. 30 | NH₄F | 1.0 | MSA *7 | 1.0 | DEGMME *11 | 20 | - | - |
| Ex. 31 | NH₄F | 1.0 | MSA *7 | 1.0 | DEGMME *11 | 40 | - | - |
| Ex. 32 | NH₄F | 1.0 | MSA *7 | 1.0 | DEGMME *11 | 50 | - | - |
| Ex. 33 | NH₄F | 1.0 | MSA *7 | 1.0 | - | - | Surfactant *24 | 0.01 |
| Ex. 34 | NH₄F | 1.0 | MSA *7 | 1.0 | - | - | Surfactant | 0.1 |
| Ex. 35 | NH₄F | 1.0 | MSA *7 | 1.0 | - | - | Surfactant | 1 |
| Ex. 36 | NH₄F | 1.0 | MSA *7 | 1.0 | DEGMME *11 | 30 | Surfactant | 0.01 |
| Ex. 37 | NH₄F | 1.0 | MSA *7 | 1.0 | DEGMME *11 | 30 | Surfactant | 0.1 |
| Ex. 38 | NH₄F | 1.0 | MSA *7 | 1.0 | DEGMME *11 | 30 | Surfactant *24 | 1 |

| | | | | | | | | |
|---|---|---|---|---|---|---|---|---|
| *6: salt of monoethanolamine and HF | | | | | | | | |
| *7: methanesulfonic acid | | | | | | | | |
| *8: ethanesulfonic acid | | | | | | | | |
| *9: *p*-toluenesulfonic acid | | | | | | | | |
| *10: dodecylbenzenesulfonic acid | | | | | | | | |
| *11: diethylene glycol monomethyl ether | | | | | | | | |
| *12: diethylene glycol monoethyl ether | | | | | | | | |
| *13: diethylene glycol monobutyl ether | | | | | | | | |
| *14: diethylene glycol dimethyl ether | | | | | | | | |
| *15: dipropylene glycol monomethyl ether | | | | | | | | |
| *16: dipropylene glycol monoethyl ether | | | | | | | | |
| *17: ethylene glycol | | | | | | | | |
| *18: propylene glycol | | | | | | | | |
| *19: propylene glycol monomethyl ether | | | | | | | | |
| *20: propylene glycol monoethyl ether | | | | | | | | |
| *21: tetrahydrofurfuryl alcohol | | | | | | | | |
| *22: γ-butyrolactone | | | | | | | | |
| *23: tetrahydrofuran | | | | | | | | |
| *24: anionic surfactant (ammonium polycarboxylate) | | | | | | | | |

**[Table 4]**

| | Evaluation results | | | | | | |
|---|---|---|---|---|---|---|---|
| | pH | Al wiring pattern | | Via hole pattern | | | |
| | | (25°C, 90 sec.) | | (25°C, 180 sec.) | | | |
| | | Removability *1 | Al corrosion *2 | Removability *1 | Al corrosion *2 | TiN corrosion *2 | Interlayer insulating film corrosion *2 |
| Ex. 1 | 1.4 | A | A | B | A | A | A |
| Ex. 2 | 1.5 | A | A | B | A | A | A |
| Ex. 3 | 1.6 | A | A | B | A | A | A |
| Ex. 4 | - | A | B | B | A | A | A |
| Ex. 5 | - | B | A | B | A | A | A |
| Ex. 6 | 2.9 | A | A | B | A | A | A |
| Ex. 7 | - | A | A | B | A | A | A |
| Ex. 8 | - | A | A | B | A | A | A |
| Ex. 9 | - | A | A | B | A | A | A |
| Ex. 10 | - | A | B | B | B | A | A |
| Ex. 11 | - | A | B | B | B | A | A |
| Ex. 12 | - | A | B | B | B | A | B |
| Ex. 13 | 5.5 | A | A | A | A | A | A |
| Ex. 14 | - | A | A | A | A | A | A |
| Ex. 15 | 5.7 | A | A | A | A | A | A |
| Ex. 16 | - | A | A | B | A | A | A |
| Ex. 17 | - | A | A | B | A | A | A |
| Ex. 18 | - | A | A | B | A | A | A |
| Ex. 19 | 5.3 | A | A | B | A | A | A |
| Ex. 20 | 5.5 | A | A | B | A | A | A |
| Ex. 21 | - | A | A | B | A | A | A |
| Ex. 22 | 5.6 | A | A | B | A | A | A |
| Ex. 23 | 5.7 | A | A | B | A | A | A |
| Ex. 24 | 5.4 | A | A | B | A | A | A |
| Ex. 25 | - | A | A | B | A | A | A |
| Ex. 26 | 1.3 | A | A | B | A | A | A |
| Ex. 27 | 1.3 | A | A | B | A | A | A |
| Ex. 28 | 4.9 | A | A | B | A | A | A |
| Ex. 29 | 4.7 | A | A | A | B | A | B |
| Ex. 30 | 5.0 | A | A | A | B | A | B |
| Ex. 31 | 5.9 | A | A | B | A | A | A |
| Ex. 32 | 5.9 | A | A | B | A | A | A |
| Ex. 33 | - | A | A | B | A | A | A |
| Ex. 34 | - | A | A | B | A | A | A |
| Ex. 35 | - | B | A | B | A | A | A |
| Ex. 36 | - | A | A | B | A | A | A |
| Ex. 37 | - | A | A | A | A | A | A |
| Ex. 38 | 5.8 | A | A | A | A | A | A |

| | | | | | | | |
|---|---|---|---|---|---|---|---|
| *1: A very good, B good, C some remaining, D impossible to remove | | | | | | | |
| *2: A no corrosion, B hardly any corrosion, C slight surface roughness occurred, D etching occurred | | | | | | | |

As is clear from the results given in Table 2 and Table 4, compared with the compositions of Comparative Examples 1 to 19, the compositions for removing a photoresist residue and polymer residue of Example 1 to 38 have sufficient residue removability with a treatment for a short time at low temperature and exhibit no corrosivity, or hardly any corrosivity, toward Al. Furthermore, it can be seen from comparison of Examples 1 and 3 to 5 that an alkylsulfonic acid such as methanesulfonic acid or ethanesulfonic acid is particularly preferable as the sulfonic acid. Moreover, it can be seen that by adding the water-soluble organic solvent and/or the surfactant, a composition having high residue removability and corrosion prevention properties can be obtained.

In accordance with the use of the composition for removing a photoresist residue and polymer residue of the present invention, a photoresist residue and a polymer residue formed by ashing of a photoresist after dry etching in a step of forming wiring comprising aluminum or an aluminum alloy on a substrate surface and in a step of forming a via hole providing interwiring connection or a contact hole providing a connection between a transistor layer and wiring therefor can be removed by a treatment for a short time at low temperature without corroding the metal wiring.

## Claims

1. A composition for removing a photoresist residue and polymer residue to remove a photoresist residue and polymer residue remaining after dry etching and after ashing of a semiconductor substrate having metal wiring comprising aluminum or an aluminum alloy, the composition comprising at least one type of fluorine compound (excluding hydrofluoric acid), at least one type of sulfonic acid, and water.

2. The composition for removing a photoresist residue and polymer residue according to Claim 1, wherein the sulfonic acid is R¹SO₃H (R¹ denotes an alkyl group having 1 to 4 carbons) or R²-A-SO₃H (R² denotes an alkyl group having 1 to 16 carbons, and A denotes a phenylene group).

3. The composition for removing a photoresist residue and polymer residue according to either Claim 1 or 2, wherein the fluorine compound is ammonium fluoride.

4. The composition for removing a photoresist residue and polymer residue according to any one of Claims 1 to 3, wherein the composition further comprises up to 50 mass % of a water-soluble organic solvent.

5. The composition for removing a photoresist residue and polymer residue according to Claim 4, wherein the water-soluble organic solvent is a cyclic amine, an ether, or an alcohol.

6. The composition for removing a photoresist residue and polymer residue according to any one of Claims 1 to 5, wherein the composition further comprises a surfactant.

7. A process for removing a photoresist residue and polymer residue remaining after dry etching and after ashing of a semiconductor substrate having metal wiring comprising aluminum or an aluminum alloy, the process comprising using a composition for removing a photoresist residue and polymer residue comprising at least one type of fluorine compound (excluding hydrofluoric acid), at least one type of sulfonic acid, and water.
